# EUROPÄISCHE PATENTSCHRIFT

(11) **EP 1 381 152 B1**
(45) Veröffentlichungstag und Bekanntmachung des Hinweises auf die Patenterteilung: **17.12.2008**
(21) Anmeldenummer: 03405490.8
(22) Anmeldetag: 02.07.2003
(51) Int. Cl.: H03B 5/36

(54) **Push-pull-CMOS-quarzoszillator**
Push-pull CMOS crystal oscillator
Oscillateur CMOS symmétrique à quartz

(30) Priorität: 11.07.2002 CH 12212002
(43) Veröffentlichungstag der Anmeldung: 14.01.2004
(73) Patentinhaber: Microdul AG, 8045 Zürich (CH)
(72) Erfinder: Thommen, Werner, 8003 Zürich (CH)
(74) Vertreter: Liebetanz, Michael

(56) Entgegenhaltungen:
- US-A- 3 902 141
- US-A- 4 405 906

## Beschreibung

Die Erfindung betrifft die Verbesserung der Störempfindlichkeit eines Push-Pull-CMOS-Quarzoszillators gemäss dem Oberbegriff des Anspruchs 1.

Die wesentlichen Grundlagen und Schaltungsprinzipien von CMOS-Oszillatoren geringer Leistung sind schon vor 25 Jahren von E. Vittoz und J. Fellrath in "CMOS analog circuits based on weak inversion operation", IEEE J.Solid-State Circuits, vol.12, pp 224-231, Juni 1977 publiziert worden. Der entscheidende Punkt für einen minimalen Strombedarf besteht in einer Amplitudenregelung, die den Oszillatorstrom reduziert, sobald eine festgelegte Spannungsamplitude des Oszillators erreicht wird. Für ein gegebenes Resonatorelement (Quarz, Piezoschwinger) ist der notwendige Strom in erster Näherung proportional zur Oszillatoramplitude. Ein Oszillator geringer Leistung wird deshalb auf eine Amplitude reguliert, die wesentlich kleiner ist als die Speisespannung. Das relativ kleine Sinussignal muss anschliessend mit einem Verstärker in ein Logiksignal mit steilen Flanken umgewandelt werden.

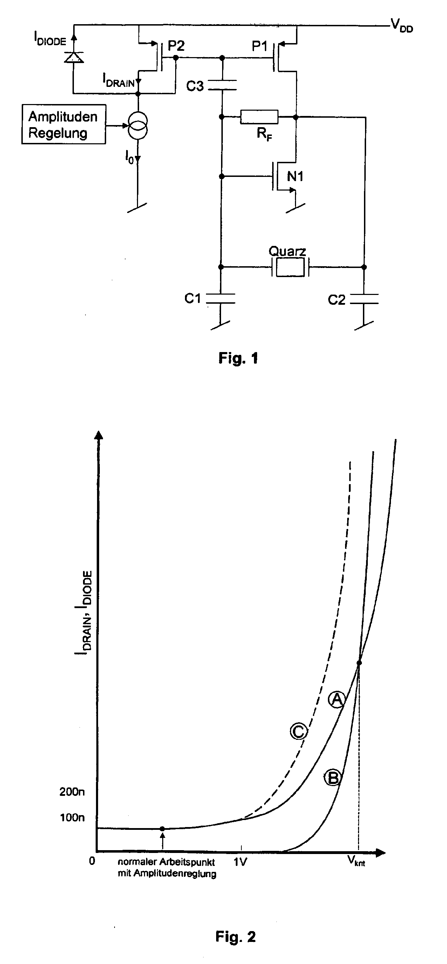

Der eigentliche Oszillator ist nichts anderes als eine einfache Verstärkerstufe mit dem Quarz in der Rückkopplung. Lastkapazitäten, die in der Darstellung eines solchen Oszillators in der Fig. 1 als C1 und C2 bezeichnet sind, sorgen für die notwendigen Phasendrehungen. Die Verstärkerstufe kann auf verschiedene Arten realisiert werden (Inverterverstärker, Stromquellenverstärker, Push-Pull Verstärker).

Ein Oszillator mit den Merkmalen des Oberbegriffs des Anspruchs 1 ist in einer Veröffentlichung von W. Thommen "An improved low power crystal oscillator", Proceedings 25th European Solid-State Circuits Conference, pp 146-149, Sept. 1999, beschrieben, Dort werden die Vor- und Nachteile der verschiedenen Oszillatortypen verglichen und gezeigt, dass nur mit dem Push-Pull Oszillator gleichzeitig der kleinste Strombedarf und die tiefste Speisespannung erreicht werden kann. Zudem ermöglicht der Push-Pull Oszillator auch eine sehr Strom sparende Signalverstärkung. Der Push-Pull Oszillator mit Amplitudenregelung eignet sich deshalb speziell für Batterie betriebene Uhrenschaltungen.

Die bisher bekannten Push-Pull Oszillatoren, wie beispielsweise aus der oben genannten Veröffentlichung von W. Thommen oder auch aus der Veröffentlichung L. L. Lewyn et. al., "CMOS oscillator subsystem optimized for minimum power consumption",Proceedings International Symposium for Circuits and Systems, pp 513-516, 1983, leiden allerdings in zwei Punkten unter einer erhöhten Störanfälligkeit verglichen mit den für Uhrenschaltungen gebräuchlichen Stromquellen-Oszillatoren. Der erste, sehr wesentliche Punkt besteht in einem parasitären, stabilen Oszillatorzustand, der einen zwanzig- bis fünfzigfach höheren Stromverbrauch bewirkt. Der zweite Punkt ist eine erhöhte Empfindlichkeit bezüglich Modulationen der Speisespannung. Beide Störanfälligkeiten sind von grossem Nachteil für einen Einsatz von Push-Pull Oszillatoren bei zum Beispiel Uhrenschaltungen.

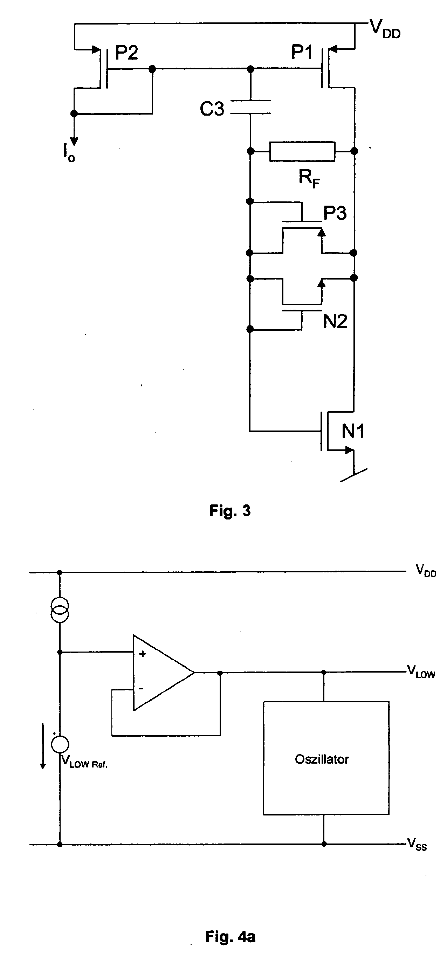

Die US-A-4,405,906 aus dem Jahre 1983 zeigt eine diskrete Quartz-Schaltung mit einem nicht linearen Rückkopplungselement zwischen den Punkten c und b der dortigen Fig. 3, welches in einer nicht dargestellten integrierten Form der Schaltung einen parasitären stabilen Oszillatorzustand auf Grund des Auftretens einer parasitären Diode zwischen Punkt c und der positiven Versorgungsspannung nicht vermeiden kann.

Ausgehend von diesem Stand der Technik liegt der Erfindung die Aufgabe zugrunde, eine oder beide Störanfälligkeiten möglichst vollständig zu beseitigen.

Diese Aufgabe wird erfindungsgemäss im Hinblick auf einen parasitären Oszillatorzustand durch die Merkmale des Anspruchs 1 gelöst.

Eine vorteilhafte Ausführungsform ist im Anspruch 2 beschrieben, welcher die Verbesserung der Empfindlichkeit bezüglich Modulation der Speisespannung betrifft.

Die Erfindung wird nun unter Bezugnahme auf die Zeichnungen an Hand von beispielhaften Ausführungsbeispielen näher beschrieben.

Es zeigen:
- Fig. 1: ein Schaltbild eines Push-Pull Oszillators nach dem Stand der Technik, hier aus der Veröffentlichung von Thommen,
- Fig. 2: eine spannungs-strom-Kurve für die Erläuterung des Zusammenhanges zwischen dem Drainstrom eines Transistors P2 bei ausgeschalteter Amplitudenregelung und der Oszillatoramplitude am Gate von Transistor N1 aus Fig. 1,
- Fig. 3: einen Oszillator mit Begrenzung der Schwingungsamplitude nach der Erfindung für eine verbesserte Speisespannungs-unterdrückung nach einem ersten Ausführungsbeispiel der Erfindung,
- Fig. 4a & 4b: eine Schaltung, zur Verbesserung der Speisespannungsunterdürckung, die nach einem zweiten Ausführungsbeispiel der Erfindung zur Erzeugung der reduzierten, gemeinsamen Speisung Vlow für Push-Pull Oszillator, Signalverstärker und für die ersten Teilerstufen geeignet ist, und
- Fig. 5: ein Spannungs-Frequenz-Diagramm der zulässigen Modulation der Speisespannung für den Frequenzbereich mit der grössten Störempfindlichkeit für drei Fälle, nämlich Stromquellenoszillator und Push-Pull Oszillator betrieben mit der vollen Speisespannung von 1.55 V und einen Push-Pull Oszillator betrieben mit der in Fig. 4 gezeigten Spannungsreduktion Vlow.

Im Folgenden werden zur Verdeutlichung die beiden Störmechanismen und die zugehörigen Abhilfemassnahmen gemäss zwei Ausführungsbeispielen der Erfindung näher beschrieben.

Zuerst wird die Frage des parasitären Oszillator-Arbeitspunktes mit stark erhöhtem Stromverbrauch erläutert.

Die Fig. 1 zeigt einen Push-Pull Oszillator nach dem Stand der Technik wie er in von Thommen in dem oben genannten Artikel veröffentlicht wurde. In der Fig. 1 ist zudem für den Transistor P2 die bei jedem PMOS-Transistor inhärent vorhandene Drain/Vdd-Diode DP eingezeichnet. DP ist in Sperrrichtung vorgespannt, so dass normalerweise kein Strom durch diese Diode fliesst. Diese Diode, die ein Teil des Transistors P2 ist (das heisst, sie ist immer vorhanden), ist dafür verantwortlich, dass der Push-Pull Oszillator ohne spezielle Vorkehrungen einen zweiten, stabilen Arbeitspunkt besitzt, der einen wesentlich grösseren Strombedarf aufweist. Gerät eine Uhrenschaltung durch irgendeine Störung (z.B. EMV-Test) in diesen Arbeitspunkt, so bleibt sie darin hängen, und die Speisungsbatterie ist durch den erhöhten Stromfluss in kurzer Zeit entladen.

Dieser Zustand wird im Zusammenhang mit den Kurven von Fig. 2 erklärt. Die Kurve A zeigt den Zusammenhang zwischen dem Drainstrom von Transistor P2 (Amplitudenregelung ausgeschaltet) und der Oszillatoramplitude am Gate von Transistor N1. Diese Schwingung wird im Push-Pull Oszillator fast vollständig durch C3 auch auf das Gate des Stromspiegels P1/P2 gekoppelt, das heisst auch auf die Diode DP. Für eine normale, kleine Schwingungsamplitude ist der Drainstrom von P2 gleich der Regelstrom I0. Sobald die Oszillatoramplitude einen Wert von etwa 1.2 Vpp überschreitet, wird DP während den positiven Spannungsspitzen leitend. Dieser parasitäre Strom durch DP wird von P2 nachgeliefert und er hat damit die gleiche Wirkung wie der Steuerstrom Io. In Kurve B von Fig. 2 ist der Gleichstromwert dieses Diodenstroms in Funktion der Oszillatoramplitude dargestellt. Die Kurven A und B schneiden sich bei einer Oszillatoramplitude von etwa 2 Vpp (= Vkrit). Kommt bei einer starken Störung (z.B: grosser Sprung der Speisespannung oder EMV-Test) kurzzeitig eine Schwingungsamplitude zustande, die grösser ist als die besagte Spannung Vkrit, so liefert die Diode DP mehr Strom als notwendig, um die Oszillatorschwingung aufrecht zu erhalten. Die Amplitudenregelung regelt den Steuerstrom Io auf null zurück und der Oszillator bleibt stabil im Arbeitspunkt Vkrit hängen.

Die Erfindung basiert auf der Einsicht, dass eine zusätzliche Spannungsbegrenzung der Oszillatoramplitude bewirkt, dass kein Schnittpunkt mit der Kurve B auftritt, was durch die Kurve C in der Fig. 2 dargestellt ist. Diese Amplitudenbegrenzung muss folgende Bedingungen erfüllen:
- sichere und zwangsläufige Amplitudenbegrenzung unterhalb dem Wert Vkrit.
- keine merkliche Oszillatordämpfung bei der normalen Amplitude, das heisst keinen zusätzlichen Strombedarf.

Die gewünschte Amplitudenbegrenzung, die zu einem Verhalten entsprechend der Kurve C führt, kann durch zwei als Clampdioden geschaltete Transistoren erreicht werden, wie dies aus der Fig. 3 zu erkennen ist, die einen Oszillator nach der Erfindung für eine verbesserte Speisespannungsunterdrückung nach einem ersten Ausführungsbeispiel der Erfindung zeigt. Die Diode N2 begrenzt die positive und Diode P3 die negative Spannungsdifferenz zwischen Oszillatoreingang und Oszillatorausgang. Die Einsatzpunkte der Begrenzung können durch die Grössen der drei beteiligten Transistoren N1, N2 und P3 (Breite/Länge des Gategebietes) relativ genau festgelegt werden, so dass die Begrenzung problemlos zwischen die normale, durch die Amplitudenregelung bestimmte Oszillatoramplitude und die kritische, parasitäre Oszillatoramplitude gelegt werden kann.

Die zweite Störanfälligkeit betrifft die Speisespannungsunterdrückung, die gemäss der Erfindung stark verbessert wird.

Beim Push-Pull Oszillator erscheint eine Speisespannungsschwankung direkt als Signal auf der P-Seite des Verstärkers, da die Source von P1 direkt an der positiven Speisespannung Vdd liegt und das Gate von P1 über C3 und C1 wechselstrommässig direkt mit der negativen Speisespannung Vss verbunden ist. Beim Stromquellenoszillator ist diese Kopplung nicht vorhanden, so dass dieser eine wesentlich bessere Speisespannungsunterdrückung aufweist als der Push-Pull Oszillator.

Die heute üblichen batteriebetriebenen Uhrenschaltungen haben einen Stromquellenoszillator, der direkt mit der Batteriespannung (normalerweise 1.55V) gespeist wird. Der Verstärker für das Oszillatorsignal und die ersten sechs bis acht Teilerstufen werden aber aus Gründen der Stromeinsparung meistens mit einer schaltungsintern erzeugten, reduzierten Spannung Vlow (ca 1.1V) betrieben.

Wenn die Schaltung zur Erzeugung von Vlow optimal dimensioniert wird, kann sie auch zur Speisung des Quarzoszillators benutzt werden, ohne dass sich eine Verschlechterung bezüglich Stromverbrauch und minimaler Speisespannung der Gesamtschaltung ergibt. Wird nun der Push-Pull Oszillator anstatt direkt mit der Batteriespannung mit der intern geregelten, reduzierten Spannung Vlow betrieben, so entfällt eine direkte Kopplung zwischen der positiven Speisespannung Vdd und der P-Seite des Oszillators. Damit ergibt sich für den Push-Pull Oszillator wieder die gleich gute Speisespannungsunterdrückung wie für den Stromquellenoszillator und der Nachteil des Standes der Technik ist aufgehoben.

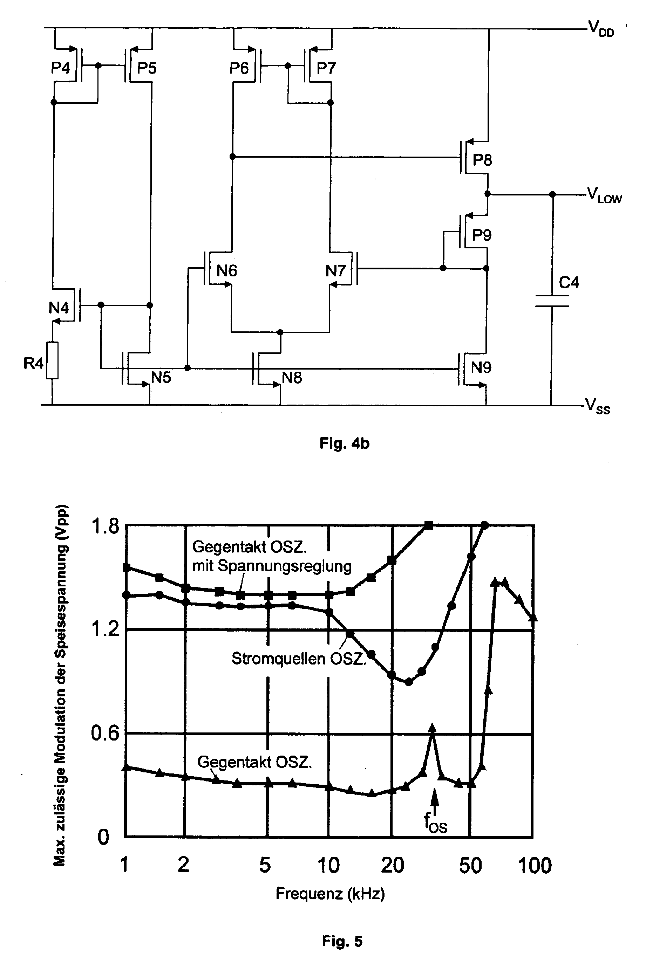

Die Fig. 4 zeigt als Beispiel eine Schaltung, die als ein zweites Ausführungsbeispiel der Erfindung zur Erzeugung der reduzierten, gemeinsamen Speisung Vlow für Push-Pull Oszillator, Signalverstärker und für die ersten sechs bis acht Teilerstufen geeignet ist. Die Fig. 4a zeigt eine prinzipielle Darstellung und die Fig. 4b zeigt eine Realisierungsmöglichkeit. Dabei sind die Bauteile wie folgt bezeichnet:

Die Transistoren N4, N5, P4 und P5 zusammen mit dem Widerstand R4 sind eine bekannte integrierbare Schaltung, siehe z.B. Vittoz / Fellrath, IEEE, JSSC, pp. 224-231, Juni 1977 zur Erzeugung sehr kleiner Ströme. Der Differenzverstärker (N6 bis N9 und P6 bis P8) regelt die Ausgangsspannung Vlow unabhängig von der Last auf die Summe der Gate-Source Spannungen der Transistoren N5 plus P9. Am Ausgang ist noch eine kleine Stützkapazität C4 von einigen Picofarad integriert.

Die Fig. 5 zeigt für den Frequenzbereich mit der grössten Störempfindlichkeit die zulässige Modulation der Speisespannung für drei Fälle, nämlich für den Stromquellenoszillator, den Push-Pull Oszillator betrieben mit der vollen Speisespannung von 1.55 V und schliesslich in einer dritten Kurve einen Push-Pull Oszillator betrieben mit der bei einer Schaltung nach Fig. 4 gezeigten und eingesetzten Spannungsreduktion Vlow. Aus diesen Kurven ist es ersichtlich, dass der Betrieb des Gegentakt-Oszillators mit reduzierter geregelter Speisespannung eine Verbesserung der Speisespannungsunterdrückung um etwa einen Faktor vier ergibt und sogar leicht besser wird als ein unter gleichen Strom- und Spannungsbedingungen betriebener Stromquellenoszillator.

## Patentansprüche

1. Resonanzoszillator mit einem Oszillatortransistor (N1), mit einer Drain-Gate-Rückkopplung zur Arbeitspunkteinstellung des Oszillatortransistors (N1), mit einem Stromspiegel (P1/P2) als Last und einer Kopplungskapazität (C3), die das Eingangssignal des Oszillatortransistors (N1) auf das gemeinsame Gate des Stromspiegels (P1/P2) koppelt, **dadurch gekennzeichnet, dass** der Oszillatortransistor (N1) ein zusätzliches, nicht lineares Drain-Gate-Rückkopplungselement (N2, P3) aus zwei parallelen, in Gegenrichtung gepolten Diodenstrukturen (N2 und P3) zur Spannungsbegrenzung enthält.

2. Resonanzoszillator nach Anspruch 1, **dadurch gekennzeichnet, dass** der Oszillator nicht mit der vollen Speisespannung, sondern mit einer reduzierten, regulierten Spannung (Vlow) gespeist wird.

## Claims

1. Resonance oscillator with an oscillator transistor (N1), with a drain-gate-feedback for adjustment of the working point of the oscillator transistor (N1), with a current mirror (P1/P2) as load and a coupling capacity (C3), coupling the entry signal of the oscillator transistor (N1) on the common gate of the current mirror (P1/P2), **characterized in that** the oscillator transistor (N1) comprises an additional not linear drain-gate-feedback element (N2, P3), consisting of two parallel diode structures (N2, P3) in opposite polarity to limit the voltage.

2. Resonance oscillator according to claim 1, **characterized in that** the oscillator is not fed the entire supply voltage, but a reduced adjusted voltage (Vlow).

## Revendications

1. Oscillateur à résonance avec un transistor d'oscillateur (N1) avec un retour de drain-grille pour l'ajustement du point de travail du transistor d'oscillateur (N1), avec un miroir de courant (P1/P2) en tant que charge et une capacité de couplage (C3), qui couple le signal d'entrée du transistor d'oscillateur (N1) sur la grille commune du miroir de courant (P1/P2), **caractérisé en ce que** le transistor d'oscillateur (N1) comprend un élément de retour drain-grille supplémentaire non linéaire (N2, P3), consistant de deux structures de diodes, parallèles et en polarité opposée, (N2, P3) pour limiter la tension.

2. Oscillateur de résonance selon la revendication 1, **caractérisé en ce que** l'oscillateur n'est pas alimenté avec la tension d'alimentation entière, mais avec une tension réduite ajustée (Vlow).
